# EUROPÄISCHE PATENTSCHRIFT

(11) **EP 4 034 493 B1**
(45) Veröffentlichungstag und Bekanntmachung des Hinweises auf die Patenterteilung: **19.11.2025**
(21) Anmeldenummer: 20788721.7
(22) Anmeldetag: 25.09.2020
(51) Int. Cl.: B81C 1/00, B81B 3/00, B23K 26/20, B23K 26/324, H01L 23/10

(54) **HERMETISCH VERSCHLOSSENE GLASUMHÄUSUNG**
HERMETICALLY SEALED GLASS ENCLOSURE
ENCEINTE EN VERRE HERMÉTIQUEMENT SCELLÉE

(30) Priorität: 26.09.2019 DE 102019125963
(43) Veröffentlichungstag der Anmeldung: 03.08.2022
(73) Patentinhaber: SCHOTT AG, 55122 Mainz (DE)
(72) Erfinder: HETTLER, Robert, 84036 Kumhausen (DE); THOMAS, Jens Ulrich, 18439 Stralsund (DE); MÄÄTTÄNEN, Antti, 33710 Tampere (SE); HERZBERG, Jochen, 4511 Allhaming (AT); ONEZAWA, Yutaka, Otsu-shi Shiga, Shiga 520--2277 (JP); ZETTERER, Thomas, 84034 Landshut (DE)
(74) Vertreter: Blumbach · Zinngrebe Patentanwälte PartG mbB
(86) Internationale Anmeldenummer: PCT/EP2020/076953
(87) Internationale Veröffentlichungsnummer: WO 2021/058768

(56) Entgegenhaltungen:
- WO-A1-2012/087369
- WO-A1-2018/211176
- DE-A1- 10 235 372

## Beschreibung

### Gebiet der Erfindung

Die Erfindung betrifft eine insbesondere mehrmalige hermetisch verschlossene Glasumhäusung sowie ein Verfahren zum Bereitstellen einer hermetisch dichten Glasumhäusung.

### Hintergrund und allgemeine Beschreibung der Erfindung

Hermetisch verschlossene Umhäusungen können beispielsweise dafür eingesetzt werden, sensible Elektronik, Schaltkreise oder beispielsweise Sensoren zu schützen. So können medizinische Implantate, beispielsweise im Bereich des Herzens, in der Retina oder für Bio-Prozessoren eingesetzt werden. Es sind Bio-Prozessoren bekannt, welche aus Titan angefertigt und eingesetzt werden.

Sensoren können mit einer erfindungsgemäßen Umhäusung für besonders widrige Umweltbedingungen geschützt werden. In diesen Bereich fallen beispielsweise auch MEMS (Mikro-Elektro-Mechanische-Systeme), Barometer, Blutgassensor, Glukosesensor, usw.

Ein weiteres Feld für den Einsatz einer erfindungsgemäßen Umhäusung lässt sich in einer Hülle für ein Smartphone, im Bereich von Virtual Reality-Brillen und ähnliches Gerät finden. Eine erfindungsgemäße Umhäusung kann auch für die Herstellung von Flusszellen bspw. im Rahmen der Elektromobilität zum Einsatz kommen. Aber auch in der Luft- und Raumfahrt, in Hochtemperaturanwendungen und im Bereich der Mikrooptik sind erfindungsgemäße Umhäusungen einsetzbar.

Den vorgenannten Einsatzzwecken ist gemein, dass an die Elektronik hohe Anforderungen hinsichtlich ihrer Robustheit gestellt werden. Um auch den Einsatz von solcher Elektronik zu ermöglichen, die erwartbar diesen äußeren Einflüssen nicht standhält, ist die Umhäusung vor solchen widrigen Umwelteinflüssen zu schützen. Darüber hinaus ist ggf. die Anforderung gestellt, dass ein Austausch mit dem Innenbereich der Umhäusung, also der von der Umhäusung gebildeten Kavität, also beispielsweise mit elektromagnetischer Strahlung insbesondere im sichtbaren Bereich und/oder im Bereich der Mikrowellenstrahlung, gewährleistet ist, also die Umhäusung zumindest teilweise - d.h. zumindest bereichsweise und/oder zumindest für einen Wellenlängenbereich - transparent ist. Diese Transparenz erlaubt Kommunikationsverfahren, Daten- oder Energieübertragung, Messungen von und mit der in der Kavität angeordneten Elektronik bzw. Sensor. Es können insbesondere optische Kommunikationsverfahren bzw. optische Daten- oder Energieübertragung ermöglicht sein.

Es ist grundsätzlich bekannt, mehrere Teile zusammenzufügen und diese Teile so anzuordnen, dass in einem Zwischenraum ein Aufnahmebereich entsteht, in welchem Komponenten beherbergt werden können. Beispielsweise zeigt EP 3 012 059 B1 ein Verfahren zur Herstellung eines transparenten Teils zum Schützen eines optischen Bauteils, welche hiermit durch Referenz inkorporiert wird. Es wird dabei ein neuartiges Laser-Verfahren eingesetzt. WO 2012/087369 A1 offenbart ein Gehäuse aus einem Basissubstrat und einem Decksubstrat, die mit einer Laserbondlinie hermetisch dicht gefügt sind. Dieses Dokument offenbart auch ein entsprechendes Herstellungsverfahren.

Problematisch kann es sein, wenn aus dem Inneren der Umhäusung eine größere Menge an Wärmeenergie freigesetzt wird, sei es über einen kurzen Zeitraum oder auch über einen längeren Zeitraum, beispielsweise im Falle des Einsatzzwecks als Bioimplantat, wenn nämlich die aus der Umhäusung austretende Wärme evtl. Schädigungen an der Umgebung erwirken kann. Es gibt bereits Studien, die den Einfluss von Wärme auf verschiedene Gewebeformen thematisieren, wobei typischerweise davon ausgegangen wird, dass eine lokale Schädigung bereits bei der Überschreitung einer lokalen Temperatur von 43 Grad Celsius entsteht, die je nach Lokalisation der Schädigung auch bereits zum Zelltod führen kann. Beispielsweise bei einer Fehlfunktion, wie einem Kurzschluss, eines Halbleiterbauteils oder einer Batterie können in kurzer Zeit Temperaturen von über 100 Grad Celsius erreicht werden. Die Erfindung ist in den unabhängigen Ansprüchen angegeben.

Die vorliegende Erfindung beschäftigt sich in dem Rahmen, dass Umhäusungen verbessert und insbesondere widerstandsfähiger aufgebaut werden sollen. Mit anderen Worten liegt der Erfindung also die Aufgabe zugrunde, eine verbesserte Umhäusung bereitzustellen, die Temperaturbelastungen für die Umgebung zu vermindern, um beispielsweise Zellschädigungen vorzubeugen.

Dies kann erreicht werden, indem der Wärmeaustrag aus der Umhäusung in die Umgebung verringert, verzögert oder beeinflusst wird. Gegebenenfalls erlaubt die erfindungsgemäße Umhäusung durch die Schutzwirkung, die sie erzeugt, den Einsatz von günstigeren Bauteilen in der Umhäusung. Insbesondere können Bauteile mit einer höheren Fehlertoleranz eingesetzt werden, die günstiger in der Herstellung sind, da die Erfindung es ermöglicht, einen Bauteilausfall zu tolerieren, wenn dieser nicht mehr zu einer Temperaturspitze insbesondere im Gewebe führt.

Noch ein weiterer Aspekt der vorliegenden Erfindung baut darauf auf, dass erkannt wurde, dass im Falle einer hermetisch verschlossenen Gehäuselösung unter Umständen
besondere Vorkehrungen zu treffen sind, um ggf. in der Umhäusung anfallende Wärme, wie insbesondere von Leistungshalbleitern, über einen längeren Zeitraum abzuführen.

Eine Umhäusung gemäß der Erfindung ist daher zur Wärmekapselung eines Funktionsbereichs ausgelegt. Mit anderen Worten ist die Umhäusung thermisch isolierend, und zwar dergestalt, dass Wärmemengen vom Austritt aus der Umhäusung in die Umgebung gehindert werden, besonders Wärmespitzen, die beispielsweise bei einem Ausfall eines elektronischen Bauteils in der Umhäusung auftreten können. Die Umhäusung umfasst hierfür zumindest ein Basissubstrat und ein Abdecksubstrat, wobei das Basissubstrat zusammen mit dem Abdecksubstrat zumindest einen Teil der Umhäusung oder die Umhäusung bildet. Ferner ist zumindest ein von der Umhäusung hermetisch verschlossener Funktionsbereich, insbesondere eine Kavität, in der Umhäusung angeordnet.

Die Umhäusung weist zumindest eine Laserbondlinie auf, so dass die Substrate der Umhäusung mittels der zumindest einen Laserbondlinie hermetisch dicht miteinander gefügt sind. Jede Laserbondlinie weist dabei eine Höhe HL senkrecht zu seiner Verbindungsebene auf. In bevorzugter Weise reicht die Laserbondlinie mit der Höhe HL in das Material des oberhalb der Laserbondlinie angeordneten Substrats hinein. Gegenüberliegend reicht die Laserbondlinie in das Material des unter der Laserbondlinie liegenden Substrats hinein. Beispielsweise wird das Abdecksubstrat mit dem Basissubstrat schmelzend miteinander gefügt. Mit anderen Worten vermischt sich bei dem Fügeschritt beziehungsweise in der Laserbondlinie schmelzend Material des einen Substrats mit Material des anderen Substrats zur Herstellung des festen und nicht lösbaren hermetischen Verbunds zwischen dem einen Substrat und dem anderen Substrat.

In einem erfindungsgemäßen Beispiel ist zwischen dem Basissubstrat und dem Abdecksubstrat zumindest ein Zwischensubstrat angeordnet, wobei in diesem Beispiel das Basissubstrat mit dem Zwischensubstrat in einer ersten Verbindungsebene mittels mindestens einer ersten Laserbondlinie gefügt ist und wobei das Abdecksubstrat mit dem Zwischensubstrat in einer zweiten Verbindungsebene mit mindestens einer zweiten Laserbondlinie gefügt ist.

In dem Funktionsbereich der Umhäusung kann Wärme erzeugt werden, beispielsweise indem dort ein Leistungselektronik-Bauteil angeordnet ist, welches in seinem Betrieb Wärme produziert, oder aber wenn es zu einem Bauteilversagen eines elektronischen Bauteils in der Umhäusung kommt, welches von einer thermischen Spitze begleitet wird.

Eine solche thermische Spitzenbelastung, also eine hohe thermische Energie in kurzer Zeit, kann zu einer punktuell bzw. bereichsweise erhöhten Temperatur in der Umgebung der Umhäusung führen, sofern die Umhäusung die Wärme ungehindert nach außen abgibt. Wenn die Umhäusung beispielsweise in einem Körper, das heißt beispielsweise in Gewebe, angeordnet ist, so kann diese erhöhte Temperatur möglicherweise zu Zellschädigungen und auch zu Zelltod führen. So ist allgemein akzeptiert, dass beispielsweise im Falle von menschlichem Gewebe ab einer Schwelltemperatur von 43 Grad Celsius Zellschädigungen und Zelltod eintreten kann, vgl. z.B. "Thresholds for thermal damage to normal tissues: an update", von P. Yarmolenko et Al., Int. J. Hyperthermia 2011, S. 320-343.

Andererseits kann bei einem Ausfall eines Leistungshalbleiters eine lokale Temperatur in dem Halbleiterbauteil erreicht werden, die weit über 100 Grad Celsius hinausgeht und auch die Schmelztemperatur des Halbleiterbauteils überschreiten kann. Um in diesem Beispiel des Defektes eines Halbleiterbauteils, welches beispielsweise als Bio-Implantat in menschlichem Gewebe eingesetzt werden soll, das menschliche Gewebe vor Zellschädigungen zu schützen, kann beispielsweise die Umhäusung dergestalt eingerichtet werden, dass die entstandene Wärme über einen längeren Zeitraum an das umgebende Gewebe abgegeben wird, so dass die Spitzentemperatur so weit herabgesetzt wird, dass die kritische Temperatur von 43 Grad Celsius nicht überschritten wird.

Dies kann im allgemeinsten Fall dadurch erreicht werden, dass zumindest das Basissubstrat und/oder das Abdecksubstrat als thermischer Isolator ausgestaltet ist, so dass die im Inneren der Umhäusung anfallende Wärme nicht oder erheblich langsamer an die Umgebung abgegeben wird.

Die Umhäusung umfasst zumindest ein Zwischensubstrat. Der eine oder die mehreren Funktionsbereiche kann an dem Zwischensubstrat angeordnet sein.

Das Basissubstrat, das eine oder die mehreren Zwischensubstrate und das Abdecksubstrat können alle als thermischer Isolator ausgestaltet sein, so dass bevorzugt die gesamte äußere Hülle der Umhäusung als thermischer Isolator wirkt.

Zumindest das Basissubstrat und/oder das Abdecksubstrat ist als thermischer Isolator ausgestaltet und besteht aus einem Material, welches ein glasartiges Material umfasst, welches Glas, Glaskeramik oder eine Kombination der vorgenannten Materialien umfasst. Insbesondere Glas bzw. glasartige Materialien haben sich als besonders vorteilhaft erwiesen, da diese sehr gut bioverträglich sind, es chemisch kompatibel mit dem menschlichen Körper ist, keine Wechselwirkungen mit dem menschlichen Organismus bekannt sind, und Glas zugleich eine hervorragende Isolationseigenschaft bereitstellt. Des Weiteren kann Glas transparent für Strahlung hergestellt werden, so dass beispielsweise ein kabelloser Informationsaustausch über Strahlung bzw. Welleninformation gewährleistet werden kann, oder aber das kontaktlose Laden von ggf. in der Umhäusung angeordneter Elektronik bzw. Batterien. Handelt es sich bei einem Substrat - insbesondere dem Abdecksubstrat - um ein im optischen Wellenlängenbereich durchlässiges Substrat, also beispielsweise ein optisch transparentes Substrat, kann eine Energiezufuhr in die Umhäusung auf optischem Weg realisiert werden, beispielsweise mittels einer in der Umhäusung angeordneten Photovoltaik-Zelle oder einem andersartigen optischen Rezeptor zur Bereitstellung von elektrischer Energie. Die Umhäusung kann dann als autarke Umhäusung beschrieben werden.

Zur Herstellung des hermetischen Verschlusses insbesondere um den Funktionsbereich herum kann insbesondere eine der Laserbondlinien den Funktionsbereich in einem Abstand DF umlaufend umschließen. In einem Beispiel ist der Abstand DF umlaufend um den Funktionsbereich konstant, so dass die Laserbondlinie allseits im ungefähr gleichen Abstand um den Funktionsbereich herum liegt. Der Abstand DF kann je nach Anwendungsfall aber auch schwanken. Dies kann produktionstechnisch günstiger sein, wenn eine Mehrzahl von Umhäusungen zugleich in einem Arbeitsschritt gefügt werden, und beispielsweise gerade Fügelinien bzw. Laserbondlinien an den jeweiligen Kontaktflächen der einzelnen Umhäusungen geführt werden. Dies kann auch der Fall sein, wenn der Funktionsbereich bzw. die Umhäusung beispielsweise rund ist oder eine beliebige Form aufweist und die Laserbondlinie, die den Funktionsbereich hermetisch verschließt, in geraden Linien gezogen wird. In einem besonderen Beispiel kann der Funktionsbereich als Kavität ausgestaltet sein und die Kavität wiederum optische Eigenschaften aufweisen, beispielsweise in Form einer Linse, wie einer Sammellinse, ausgeformt sein, und die Laserbondlinie in einem davon unterschiedlichen Muster um die Kavität herum gezogen sein.

Der Funktionsbereich der Umhäusung ist beispielsweise hergerichtet zur Aufnahme zumindest eines Beherbergungs-Objekts, wie beispielsweise ein elektronischer Schaltkreis, ein Sensor oder MEMS, so dass innerhalb der Umhäusung zumindest ein Beherbergungs-Objekt angeordnet ist. Das zumindest eine Beherbergungs-Objekt kann einen Leistungshalbleiter-Chip, z.B. eine GaN-LED, einen SiC-, GaAs- oder GaN-Leistungstransistor umfassen.

Das Beherbergungs-Objekt ist dabei bevorzugt in einer Kavität angeordnet, die allseits bzw. vollständig von der Umhäusung umschlossen ist. Der Funktionsbereich bzw. die Kavität kann in das Basissubstrat eingebracht sein, also indem beispielsweise aus dem Basissubstrat eine Vertiefung beispielsweise abrasiv ausgehöhlt ist und somit der Funktionsbereich und/oder das zumindest eine Beherbergungsobjekt unten und seitlich von dem Material des Basissubstrats umgeben ist. Der Funktionsbereich bzw. die Kavität kann auch oberhalb des Basissubstrats angeordnet sein. Die Kavität weist eine Unterseite, einen seitlich umlaufenden Rand und eine Oberseite auf. Es kann alternativ die Oberseite als eine erste Seite beschrieben werden, die Unterseite als eine zweite, der ersten Seite gegenüberliegende Seite und der Rand als der Zwischenbereich zwischen erster und zweiter Seite, wobei der Rand typischerweise im Wesentlichen senkrecht auf die erste und/oder zweite Seite steht. Es kann außerdem der Rand eine Höhe von 0 aufweisen, so dass dann die Oberseite direkt auf der Unterseite aufliegt, zum Beispiel dann, wenn der Funktionsbereich lediglich eine dünne Funktionsschicht aufweist.

Die Umhäusung umfasst zumindest zwei Kavitäten, insbesondere zum Aufnehmen zumindest eines Beherbergungsobjekts in jeweils einer Kavität. Mit anderen Worten können die Beherbergungs-Objekte in einer Umhäusung auf verschiedene Kavitäten aufgeteilt werden, so dass sich eine räumliche Trennung der Bauteile voneinander in derselben Umhäusung ergibt. Beispielsweise kann hierdurch eine ggf. installierte Batterie bzw. Speicherzelle von weiteren Bauteilen getrennt in der Umhäusung beherbergt werden. Hierdurch kann verbessert werden, dass beispielsweise in dem Fall eines Bauteil-Versagens weitere Bauteile von der auftretenden Hitze geschädigt oder zerstört werden. So kann bei der Überhitzung eines Leistungstransistors die Batterie bzw. Speicherzelle geschützt werden, so dass die Batterie bzw. Speicherzelle nicht ebenfalls überhitzt und Wärme freisetzt. Es wird dabei insgesamt also weniger Wärme akkumuliert bzw. an die Umgebung abgegeben, und insbesondere bleibt dadurch auch die Gesamttemperatur der Umhäusung niedriger, so dass im Falle eines Bio-Implantats Zellschädigungen verringert bzw. vermieden werden können.

Die Verringerung der Wärmeabgabe aus der Umhäusung in die Umgebung kann also dadurch verbessert werden, dass Bauteile bzw. Beherbergungs-Objekte auf verschiedene Kavitäten aufgeteilt werden, um dadurch beispielsweise "Kettenreaktionen" zu verhindern, bei welchen im Falle eines ersten Bauteil-Versagens weitere Bauteile versagen und zusätzliche Wärme freigeben würden. Ein weiterer Aspekt ist der, dass durch die Aufteilung der Beherbergungs-Objekte auf verschiedene Kavitäten die jeweiligen Bauteile auch zusätzlich
geschützt sind. So kann ein Speicher-Bauteil in einer eigenen Kavität angeordnet werden, und somit sogar im Fall eines Bauteil-Versagens beispielsweise eines Leistungstransistors o.ä. in der Umhäusung ggf. trotzdem noch sicher ausgelesen bzw. ausgebaut werden.

In der einen oder den mehreren Kavitäten kann des Weiteren alternativ oder kumulativ ein Isolationsmedium eingebracht werden zur Verbesserung der Isolationswirkung. Mit anderen Worten wird in die Kavität ein vom Glas verschiedenartiges Isolationsmedium eingefüllt. Das Isolationsmedium ist dabei insbesondere ein Fluid, beispielsweise eine thermisch isolierende Flüssigkeit oder ein isolierendes Gas. Unter einem Isolationsmedium wird auch verstanden, dass die Kavität oder die mehreren Kavitäten evakuiert sind, also die Kavität(en) "mit Vakuum gefüllt" sind, denn auch ein Vakuum ist gut als Isolationsmedium geeignet. Aufgrund der hermetischen Versiegelung der Kavität(en) - in besonders vorteilhafter Weise mittels des Laser-Schweißverfahrens - kann dabei sichergestellt werden, dass die Befüllung der Kavität(en) mit Isolationsmedium bzw. mit Vakuum auf Dauer aufrecht erhalten werden kann.

Mit anderen Worten ist es bevorzugt, wenn mehrere Beherbergungs-Objekte in der Umhäusung angeordnet sind, wobei die Beherbergungs-Objekte auf verschiedene Kavitäten aufgeteilt sind.

Die hermetisch verschlossene Umhäusung weist Glasdurchführungen (Vias) in dem zumindest zwei Kavitäten trennenden Zwischensubstrat auf. Die Glasdurchführungen sind vorgesehen zum elektrischen Verbinden der in verschiedenen Kavitäten angeordneten Beherbergungs-Objekte. Es handelt sich bei den Glasdurchführungen um "through glass vias" (TGV), wobei die Vias mit elektrisch leitendem Material gefüllt werden.

Die Umhäusung kann zumindest eine elektrische Verbindungsschicht auf zumindest einem der Zwischensubstrate aufweisen. Dann ist es besonders einfach, die Bauteile bzw. Beherbergungs-Objekte in der jeweiligen Kavität anzuordnen und elektrisch zu verbinden. Die elektrische Verbindungsschicht ist beispielsweise an der Unterseite einer oder mehrerer oder aller Kavitäten angeordnet und mit der oder den Glasdurchführung(en) kontaktiert.

Zwar ist es eine bevorzugte Bauform, dass die Umhäusung eine Kavität aufweist, in der insbesondere ein oder mehrere Bauteile angeordnet werden können. Jedoch ist die erfindungsgemäße Umhäusung nicht auf die Bauform mit Kavität beschränkt, da vielmehr ein Funktionsbereich eine Funktion aufweisen oder ausführen kann ohne dabei eine Kavität im Sinne eines Hohlraumes aufweisen zu müssen. Ein Beispiel für einen solchen Funktionsbereich ist die Aufbringung einer elektrischen Verbindungsschicht auf einem Substrat, wodurch bereits ein Funktionsbereich ohne Hohlraum gebildet wird. Eine solche elektrische Verbindungsschicht kann beispielsweise zwei andere Funktionsbereiche elektrisch verbinden, beispielsweise zwei Kavitäten.

Ein Substrat kann auch mehrere Schichten umfassen und somit ein Mehrschichtverbund sein. So ein Mehrschichtverbund kann dann als eine der Schichten der Umhäusung mit dem oder den anderen Substraten mittels des Laserfügeverfahrens verbunden werden. Dies kann also bedeuten, dass der Mehrschichtverbund im Vorhinein vorbereitet wird, beispielsweise indem eine Beschichtung auf einem Substrat aufgetragen wird und so ein Zweischichtverbund hergestellt wird, und dieser Zweischicht- bzw. Mehrschichtverbund als Ganzes mit der oder den anderen Schichten im Herstellungsprozess der Umhäusung verbunden wird zur Herstellung der Umhäusung.

Durch den Einsatz eines Mehrschichtverbunds in der Umhäusung können der Umhäusung weitere Materialeigenschaften hinzugefügt werden. Beispielsweise kann der Mehrschichtverbund bereits eine innere Spannung oder Vorspannung aufweisen bzw. eine Vorspannungsrichtung, so dass bei dem Laserfügen des Mehrschichtverbunds mit der zumindest einen weiteren Schicht der Umhäusung der innere Spannungsbetrag verbessert werden kann. Beispielsweise kann dies die Widerstandsfähigkeit der Umhäusung verbessern, wenn ein im Vorhinein gehärteter Mehrschichtverbund eingesetzt wird. Dies kann darin resultieren, dass die Umhäusung als Ganzes die Eigenschaften einer gehärteten Umhäusung annimmt. Zusätzlich oder alternative kann der Mehrschichtverbund eine oder mehrere Beschichtungslagen aufweisen, also beispielsweise eine solche Beschichtung, die möglicherweise Anlass für Komplikationen gibt, wenn diese Schicht mittels des Laserfügeverfahrens gefügt werden müsste. Mit anderen Worten ist ein Substrat, welches als Mehrschichtverbund bereitgestellt wird, als "Pack" oder "Stapel" bereitgestellt mit Schichten, die bereits miteinander verbunden sind. Kann eine optische Beschichtung umfassen

Zum Fügen der Substrate miteinander wird ein Laser-Fügeverfahren eingesetzt. Das Laser-Fügeverfahren kann derart lokal kontrolliert werden, dass durch den Fügevorgang nur eine geringe bzw. vernachlässigbare Wärmemenge in den Funktionsbereich bzw. in die Kavität(en) eintritt. Das Laser-Fügeverfahren findet somit quasi bei Raumtemperatur statt, d.h. die Umhäusung wird quasi bei Raumtemperatur gefügt.

Die Laserbondlinie reicht insbesondere mit der Höhe HL in das Material des über der Laserbondlinie angeordneten Substrats hinein. In der Laserbondlinie findet ein lokaler Aufschmelzvorgang in dem Material statt, so dass, wenn die Laserbondlinie zum Teil in ein erstes und zu einem weiteren Teil in ein zweites Substrat hineinreicht, die beiden Substrate schmelzend miteinander gefügt werden. Mit anderen Worten wird mittels der bzw. den Laserbondlinie(n) das Basissubstrat mit dem oder den Zwischensubstraten und dem Abdecksubstrat schmelzend miteinander gefügt.

Die Laserbondlinie ist mit anderen Worten so angeordnet bzw. aufgebaut, dass sie Lücken in dem hermetischen Verschluss der Umhäusung zu überbrücken vermag, indem beispielsweise zwei Bauteile mittels der Laserbondlinie schmelzend miteinander gefügt werden. In dem Fall, dass die Umhäusung lediglich Basissubstrat und Abdecksubstrat aufweist, um den Funktionsbereich vollständig zu umschließen, wird der Kontaktbereich zwischen Basissubstrat und Abdecksubstrat, also die Stelle bzw. der Bereich bzw. die Fläche, an welcher Abdecksubstrat und Basissubstrat aneinandergrenzen, mittels der Laserbondlinie überbrückt bzw. verbunden. Im Ergebnis bildet sich die Umhäusung aus, als wäre sie einstückig geformt, wobei auch die Trennstelle zwischen den Bauteilen mittels der Laserbondlinie hermetisch verschlossen ist.

Mit anderen Worten werden zum Bereitstellen einer Umhäusung in einem ersten Schritt ein erstes (Basissubstrat) und zumindest ein zweites Substrat (Abdecksubstrat) bereitgestellt, wobei das zumindest eine zweite Substrat (Abdecksubstrat) transparentes Material umfasst, also zumindest bereichsweise oder teilweise für zumindest einen Wellenlängenbereich transparent ist. Mehrere Umhäusungen können vorteilhaft gemeinsam beispielsweise aus einem gemeinsamen Ausgangssubstrat gefertigt werden, beispielsweise in Form von Wafern eines Waferstapels, oder nur das Basissubstrat als Wafer bereitgestellt werden. Dann kann im Verfahren zur Herstellung einer Umhäusung noch die Vereinzelung der jeweiligen Umhäusung mittels eines Schneid- oder Abtrenn-Schritts folgen.

Dabei werden die Substratschichten bzw. das Basissubstrat mit dem Abdecksubstrat unmittelbar und in direktem Kontakt zueinander gestapelt, also aneinander angeordnet. Zwischen den Substratschichten sind Fremdmaterialien bevorzugt möglichst ausgeschlossen, so dass ein möglichst schlüssiger und flächiger Kontakt von einer Substratschicht zur benachbarten Substratschicht entsteht. Im Falle von zwei Substraten wird also beispielsweise das Basissubstrat im direkten Kontakt mit dem Abdecksubstrat zueinander angeordnet, insbesondere ohne dass andere Materialien oder ein Abstand zwischen Basissubstrat und Abdecksubstrat vorhanden wäre. Im Beispiel von mehr als zwei Substraten wird das Basissubstrat unmittelbar benachbart zu dem oder der ersten der Zwischensubstratschichten angeordnet, das Abdecksubstrat wiederum unmittelbar benachbart zu dem oder der letzten der Zwischensubstratschichten angeordnet.

Anschließend werden die Substrate miteinander mit dem neuen Laserfügeverfahren gefügt. Dabei wird eine flächige Substratschicht mit der unmittelbar benachbart angeordneten flächigen Substratschicht direkt miteinander gefügt, ohne dass hierfür Fremdmaterialien oder nichtflächige Materialien bzw. Zwischenschichten vorgesehen oder benötigt sind. Die Substrate werden also jeweils direkt miteinander gefügt. Die in den flächigen Kontaktbereich zwischen zwei Substratschichten eingebrachte erzeugte Laserbondlinie verbindet nicht-lösbar die direkt aneinander, d.h. unmittelbar benachbart angeordneten Substratschichten miteinander. Der Aufschmelzbereich der Laserbondlinie befindet sich also in beiden Substraten, und geht nahtlos von dem ersten Substrat in das unmittelbar benachbart angeordnete zweite Substrat über, also beispielsweise von dem Basissubstrat in das Abdecksubstrat. Das neuartige Laserfügeverfahren hebt sich dabei unter anderem auch dadurch von früheren Verfahren ab, bei welchem mittels Laser Substrate miteinander verbunden werden, dass das vorliegende Verfahren erheblich geringere Mengen an thermischer Energie in den Substratstapel bzw. die Umhäusung einbringt, so dass auch nur wenig thermische Energie in die übrige Umhäusung dissipiert und im Funktionsbereich angeordnete Bauteile/Komponenten nur eine geringe Temperaturerhöhung erhalten. Dies ist noch bedeutender, da im vorliegenden Fall zumindest eines der Substrate der Umhäusung besonders gute thermische Isolationseigenschaften aufweist und somit die thermische Energie, die beim Laserfügen in die Umhäusung appliziert wird, ggf. länger in der Umhäusung verweilt, bevor sie in die Umgebung abgegeben wird. Der Einsatz von thermisch isolierenden Materialien für eine Umhäusung, bei der Bauteile/Komponenten in der Nähe zu einer Laserfügelinie angeordnet sind bzw. sein können ist daher erst mit dem vorliegenden, neuartigen Laserfügeverfahren in dieser Kombination möglich.

Es bildet sich somit von einer Substratschicht zur nächsten Substratschicht ein unmittelbarer, flächiger oder sogar vollflächiger Übergang heraus, wie beispielsweise ein Substrat-Substrat-Übergang oder ein Glas-Glas-Übergang. Es bildet sich ein lokal begrenztes Volumen als Fügezone bzw. Laserbondlinie, in welchem ein Materialtransfer bzw. -vermischung zwischen den benachbarten Substratschichten, welche insbesondere flächig ausgebildet sind, vorliegt. Mit anderen Worten dringt Material des ersten Substrats, beispielsweise des Abdecksubstrats, in das benachbart angeordnete Substrat, beispielsweise das Zwischensubstrat oder das Basissubstrat, ein und umgekehrt, es dringt also Material von dem benachbart angeordneten Substrat in das erste Substrat ein, so dass in der Fügezone eine vollständige Materialdurchmischung der benachbart angeordneten Substrate untereinander vorliegt. Die Fügezone kann daher auch als Konvektionszone bezeichnet werden.

Die neue Laserfügetechnik zur Erzeugung des nicht-lösbaren Glas-Glas-Übergangs bzw. Substrat-Substrat-Übergangs ist dabei in besonders vorteilhafter Weise frei von Zwischenschichten, Glasfritten, Folien oder Kleber, die in früheren bekannten Verfahren zwischen die Substrate eingebracht werden mussten. Vielmehr lässt sich die nicht-lösbare Verbindung ohne entsprechende störende Zwischenschichten bzw. Zusatzmaterialien erzeugen. Dies spart den Einsatz von zusätzlichen Materialien, steigert die erzielbare Härte des Endprodukts und ermöglicht eine sichere hermetische Versiegelung des Funktionsbereichs bzw. der Kavität/en. Die Laserfügezone lässt sich im fertigen Endprodukt dabei beispielsweise durch die spezifische lokale Brechungsindexänderung des Materials in dem kleinen bzw. lokalen Verschmelzungsbereich nachweisen.

In einer vorteilhaften Weiterbildung kann in zumindest einem der Substrate ein Marker eingebracht sein.

Die Umhäusung ist bevorzugt zumindest teilweise und/oder bereichsweise für einen Wellenlängenbereich transparent. In einem einfachen Beispiel ist das Abdecksubstrat der Umhäusung im sichtbaren Wellenlängenbereich optisch transparent, also durchsichtig. Aber auch Transparenz beispielsweise im Röntgenbereich kann vorteilhaft sein. Mit anderen Worten umfasst beispielsweise das Abdecksubstrat bevorzugt ein glasartiges Material. Das Abdecksubstrat ist dadurch bevorzugt transparent bzw. durchlässig für zumindest einen Wellenlängenbereich, beispielsweise optisch transparent. Je nach Anwendungsfall kann es auch vorteilhaft sein, wenn die Kappe opak ausgebildet ist, d.h. optisch intransparent, in der Art von Milchglas. Auch eine reduzierte Transparenz bzw. Teildurchlässigkeit kann für die Funktion ausreichen. Erfindungsgemäß besteht zumindest eines aus Basissubstrat oder Abdecksubstrat aus einem Material, welches ein glasartiges Material umfasst, welches Glas, Glaskeramik oder eine Kombination der vorgenannten Materialien umfasst. In einer bevorzugten Ausführungsform ist das Abdecksubstrat eine Glasplatte, beispielsweise aus gehärtetem Glas, Spezialglas oder hochtemperaturfestem Glas, beispielsweise aus dem Produktportfolio der Anmelderin.

Die Umhäusung kann so gestaltet werden, dass der zumindest eine Funktionsbereich der Umhäusung eingerichtet werden kann zur Aufnahme von zumindest einem Beherbergungs-Objekt einer Größe von 10mm x 10mm oder kleiner, bevorzugt einer Größe von 5mm x 5mm oder kleiner, weiter bevorzugt von 2mm x 2mm oder kleiner oder auch 1mm x 1mm oder kleiner. Die Größe der Umhäusung richtet sich dann nach der Größe und Anzahl der Beherbergungs-Objekte in den Funktionsbereichen bzw. Kavitäten der Umhäusung. Beispielsweise bei Anordnung von jeweils einem Beherbergungs-Objekt einer Größe von etwa 5mm x 5mm in jeder von vier Kavitäten der Umhäusung, wobei je zwei Kavitäten nebeneinander und je zwei Kavitäten übereinander angeordnet sind, wird die Umhäusung typischerweise eine Größe von 13mm x 13mm oder größer aufweisen, so dass die Beherbergung der Objekte in den Kavitäten sichergestellt ist.

Eine Größenangabe aus der Praxis, die sich durch das bevorzugte Herstellungsverfahren bedingt, die jedoch nicht per se als Größenbeschränkung verstanden werden soll, besteht in der Größe der zu schneidenden Wafer. Der Einsatz von Wafern zur Herstellung ist jedoch nur als Beispiel zu verstehen. Es ist durchaus möglich, beispielsweise Glasplatten zur Herstellung der transparenten Umhäusung einzusetzen, die auch größere Abmessungen als typische Wafergrößen aufweisen kann.

Im Augenmerk der Erfindung liegt auch ein Verfahren zum Bereitstellen einer hermetisch dichten Umhäusung, wobei von der Umhäusung ein Funktionsbereich, insbesondere eine Kavität, umschlossen wird. Das Verfahren weist die Schritte auf Bereitstellen zumindest eines Basissubstrats, zumindest eines Zwischensubstrats und eines Abdecksubstrats, wobei das Abdecksubstrat zumindest teilweise oder bereichsweise zumindest für einen Wellenlängenbereich transparent ist und daher ein transparentes Abdecksubstrat ist; Anordnen von zumindest einem Beherbergungs-Objekt in dem Funktionsbereich, also insbesondere in einer Kavität; Anordnen des Abdecksubstrats auf dem Basissubstrat oberhalb des zumindest einen Beherbergungs-Objekts, wobei sich zwischen dem Basissubstrat, dem Zwischensubstrat und dem Abdecksubstrat jeweils zumindest eine Kontaktfläche ausbildet, Hermetisch dichtes Verschließen der Kavitäten durch Ausbilden zumindest jeweils einer Laserbondlinie auf den Kontaktflächen , wobei zumindest eines aus Basissubstrat oder Abdecksubstrat thermisch isolierend ausgestaltet ist.

In einem Beispiel, das nicht zur Erfindung gehört, wird das Abdecksubstrat mit dem Basissubstrat mittels der Laserbondlinie miteinander gefügt. Mit anderen Worten wird das Abdecksubstrat ohne Zwischenschicht auf oder in das Basissubstrat gesetzt und mit dem Basissubstrat unmittelbar und direkt mit einer oder einer Mehrzahl von gemeinsamen Laserbondlinien miteinander gefügt. In diesem Fall bilden das Abdecksubstrat zusammen mit dem Basissubstrat gemeinsam die vollständige Umhäusung. Mit anderen Worten ist kein zusätzliches oder weiteres Teil benötigt, um die Umhäusung zu bilden bzw. zu schließen, sondern das Basissubstrat, die zumindest eine Laserbondlinie und das Abdecksubstrat verschließen gemeinsam den Funktionsbereich bzw. die Kavität vollständig und hermetisch dicht. Andererseits kann es vorteilhaft sein, wenn ein oder mehrere Zwischensubstrate eingesetzt werden, beispielsweise um mehrere Kavitäten voneinander zu trennen.

Die zumindest zwei Substrate bzw. das Basissubstrat und das Abdecksubstrat werden so aneinander angeordnet bzw. angebracht, dass sie flächig aneinander zu liegen kommen, ohne dass andere Schichten, Lagen oder Einschlüsse zwischen den zumindest zwei Substraten bzw. zwischen Basissubstrat, Abdecksubstrat und ggf. Zwischensubstrat vorhanden sind. Möglicherweise sind aus technischen Gründen geringste Gaseinschlüsse zwischen den Schichten im Bereich der Kontaktflächen nicht zu vermeiden, die sich auch aus eventuellen Unebenheiten ergeben. Beispielsweise kann durch eine Druckerhöhung, wie insbesondere durch ein Pressen, oder eine Oberflächenbehandlung der Substratschichten, insbesondere der Kontaktflächen, wie einem Schleifprozess, die Menge des im Bereich der flächig aufliegenden Kontaktfläche eingeschlossenen Gases weiter reduziert werden. Das vorherige Evakuieren ist vorteilhaft. Auch eine Befüllung mit einer Gasart oder auch einer Flüssigkeit kann je nach Prozessparametern und einzusetzenden Materialien vorteilhaft sein.

Es ist besonders bevorzugt, wenn ein möglicherweise auftretender Spalt zwischen den Substraten kleiner oder gleich 5 µm dick ist, weiter bevorzugt kleiner oder gleich 1 µm. Ein solcher Spalt entsteht beispielsweise durch Toleranzen bei der Substratherstellung, durch thermische Beeinflussung oder durch Einschlüsse von Partikeln wie Staub. Auch bei einer solchen tolerierbaren Beabstandung, die im Rahmen dieser Erfindung auch als unmittelbar benachbart angesehen wird, ist es möglich, mit dem Laser derart zu fügen, dass die Fügezone eine Dicke zwischen 10 bis 50 µm aufweist und somit eine hermetische Versiegelung sichergestellt ist. Auch in diesem Fall reicht die Fügezone vom ersten Substrat bis in das benachbart zum ersten Substrat angeordnete zweite Substrat. Die Fügezone wird also im Kontaktbereich zwischen ersten und zweiten Substrat eingebracht und verschmelzt die Substrate direkt miteinander zu einem untrennbaren Verbund. Mit anderen Worten wird mit dem Fügen der benachbart angeordneten Substrate in der Fügezone direkt Material beider Substrate angeschmolzen, welches in der Fügezone liegt, und es vermischt sich das Material des ersten Susbtrats mit dem Material des zweiten Substrats zu einem untrennbaren einstückigen Verbund. Die solchermaßen hergestellte Umhäusung weist somit jedenfalls in der Fügezone einen einstückigen, das heißt monolithischen Verbund zwischen den Substraten auf.

Eine Kontaktfläche muss nicht optisch transparent sein. Weiter ist es vorteilhaft, wenn das transparente Substrat im sichtbaren Wellenlängenbereich opak ausgebildet ist. Lediglich das Substrat, durch welches der Laser durchtritt, um zu der Kontaktfläche zu gelangen, weist zumindest ein spektrales "Fenster" auf, so dass zumindest die Wellenlänge des eingesetzten Lasers durch das Substrat zumindest teilweise oder zumindest bereichsweise hindurchtreten kann. Die Kontaktfläche ist so beschaffen, dass der Laser an dieser eine Energiedeposition vollziehen kann. Beispielsweise können die Oberflächen der beiden aneinander liegenden Substrate angesprengt sein und weiter vorzugsweise eine Rauheit im nm-Bereich aufweisen. An dieser Fläche wird der Laser zumindest teilweise absorbiert, so dass dort Energie eingebracht werden kann. Generell ist eine Kontaktfläche im Sinne dieser Anmeldung als eine Fläche zu verstehen, an welcher der eintreffende Laserstrahl Energie deponieren kann und so ein Fügeprozess entlang der Kontaktfläche durchgeführt werden kann.

Zur Bildung der Laserbondlinie wird insbesondere ein Laserstrahl umlaufend um den Funktionsbereich herumgeführt, so dass der Funktionsbereich entlang der zumindest einen Kontaktfläche umlaufend hermetisch verschlossen wird. Gegebenenfalls kann der Laserstrahl mehrfach umlaufend herumgeführt werden und/oder gegebenenfalls eine Mehrzahl von Laserbondlinien ausgebildet werden.

Im Rahmen der Erfindung liegt auch die Verwendung einer nach dem vorstehend beschriebenen Verfahren hergestellten Umhäusung mit darin eingeschlossener hermetisch verschlossenem Funktionsbereich bzw. Kavität als medizinisches Implantat bzw. Bio-Implantat oder als Sensor.

Im Folgenden wird die Erfindung anhand von Ausführungsbeispielen und unter Bezugnahme auf die Figuren näher erläutert, wobei gleiche und ähnliche Elemente teilweise mit gleichen Bezugszeichen versehen sind und die Merkmale der verschiedenen Ausführungsbeispiele miteinander kombiniert werden können.

### Kurzbeschreibung der Figuren

Es zeigen:
- Fig. 1: Draufsicht auf eine Umhäusung,
- Fig. 2: Seiten-Schnittansicht einer Umhäusung,
- Fig. 3: Detailansicht auf eine Fügezone,
- Fig. 4: Seiten-Schnittansicht durch den Funktionsbereich einer Umhäusung,
- Fig. 5: Seiten-Schnittansicht durch den Funktionsbereich einer Umhäusung mit zwei Kavitäten,
- Fig. 6a-6e: Beispiel für Schritte der Herstellung einer Umhäusung,
- Fig. 7 und 8: weitere Seiten-Schnittansichten durch den Funktionsbereich zweier Umhäusungen,
- Fig. 9: Beispiel für weitere Schritte der Herstellung einer Umhäusung.

### Detaillierte Beschreibung der Erfindung

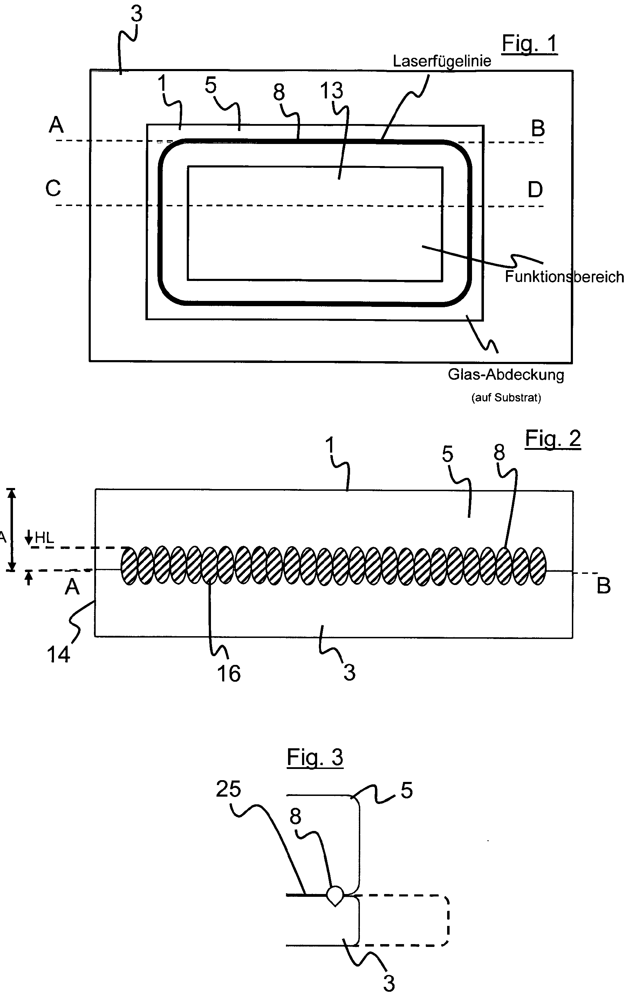

Fig. 1 zeigt eine Draufsicht auf eine Umhäusung 1 mit Merkmalen der Erfindung, wobei die umlaufende Laser-Fügezone 8 den Funktionsbereich 13 umgibt. Der Funktionsbereich 13 kann verschieden aufgebaut sein. Beispiele für verschiedenartige Gestaltunges des Funktionsbereichs 13, finden sich auch in den weiteren Figs. 3 bis 8, die Schnittansichten zeigen und somit die vertikale Struktur des Funktionsbereichs 13 aufzulösen vermögen. Die verschiedenen Gestaltungen des Funktionsbereichs 13 lassen sich dabei graphisch in der Fig.3 so zusammenfügen, da alle Aufsichten schematisch gleich darstellbar sind.

Der Funktionsbereich 13 kann verschiedene Aufgaben realisieren, beispielsweise kann dieser als ein optischer Rezeptor ausgestaltet sein, oder ein technisches, elektromechanisches und/oder elektronisches Bauteil 2 aufweisen, welches im Funktionsbereich 13 angeordnet ist. Es können auch mehrere dieser Aufgaben im Funktionsbereich 13 realisiert werden. Die Umhäusung 1 wird oberseits von dem oberen Substrat 5, wie beispielsweise einer Kappe 5, abgedeckt. Die oder zumindest eine Laser-Fügezone 8 reicht in dieses obere Substrat 5 hinein.

Bezugnehmend auf Fig. 2 ist eine erste Schnittansicht einer ersten Ausführungsform einer Umhäusung 1 gezeigt, welche ein Basissubstrat 3 und ein Abdecksubstrat 5 aufweist. Mit anderen Worten ist die Umhäusung 1 aus zwei Schichten nämlich der Basisschicht 3 und der Abdeckschicht 5 aufgebaut oder zusammengesetzt. Fig. 3 zeigt überdies den Aufbau der Laser-Fügelinie 8 aus einer Aneinanderreihung von einer Mehrzahl von Laser-Pulstrefferbereichen 16, welche so dicht aneinander gesetzt sind, dass das Material des Basissubstrats 3 und des Abdecksubstrats 5 miteinander lückenlos verschmilzt und somit den Funktionsbereich 13 bzw. die Kavität 12 (in dieser Ansicht hinter der Laser-Fügelinie 8 angeordnet) hermetisch verschließt.

Fig. 3 zeigt einen Detailausschnitt auf den Fügebereich, wobei die Interface-Zone, d.h. die Kontaktfläche 25, und die Laser-Fügezone 8 dargestellt sind. Die Laser-Fügezone 8 ist im Bereich der Kontaktfläche 25 angeordnet, um die beiden Substrate 3, 5 miteinander zu fügen.

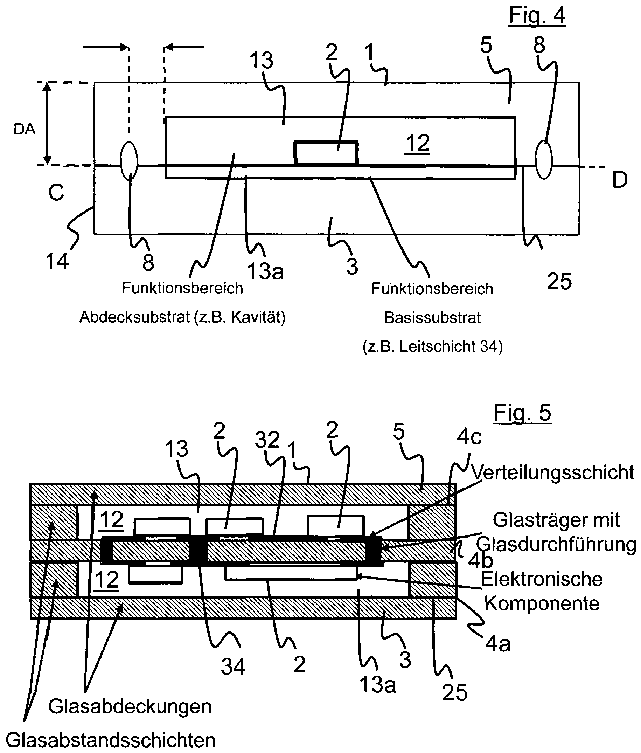

Fig. 4 zeigt eine Schnittansicht einer Ausführungsform einer Umhäusung 1 entlang der Linie C->D, wie sie in Fig. 1 dargestellt ist. Fig. 4 zeigt somit einen Schnitt durch den Funktionsbereich 13, 13a, der sich beispielsweise als durchgehender Hohlraum oder Kavität in der Umhäusung 1 erstreckt. Mit anderen Worten erstreckt sich die Kavität von dem Basissubstrat 3 bis in das Abdecksubstrat 5, und liegt beispielsweise in Form einer Ausnehmung aus Basissubstrat 3 und/oder dem Abdecksubstrat 5 vor. Der Funktionsbereich 13 ist hier als Ausnehmung in dem Abdecksubstrat 5, der Funktionsbereich 13a als Ausnehmung in dem Basissubstrat 3 ausgebildet, beispielsweise mittels eines abrasiven Verfahrens wie einem Sandstrahlverfahren. Mit anderen Worten weist das Basissubstrat 3 eine Vertiefung 13a auf, und das Abdecksubstrat 5 eine Vertiefung 13, in die ein Beherbergungsobjekt 2 eingesetzt ist.

Beispielsweise kann der Funktionsbereich 13a auch eine aktive Schicht umfassen, z.B. eine elektrisch leitfähige Schicht 34. Die aktive Schicht des Funktionsbereichs 13a kann auch einen Photorezeptor umfassen, beispielsweise in der Form einer Photovoltaikzelle, so dass dieser zur Erzeugung von elektrischer Leistung hergerichtet ist. Dann kann es sich bei der Umhäusung 1 um eine autarke Umhäusung 1 handeln. Der darüber im Bereich des Abdecksubstrats 5 angeordnete Funktionsbereich 13 kann die Kavität 12 umfassen.

Umlaufend um den Funktionsbereich 13, 13a ist die Laser-Fügezone 8 angeordnet, mittels welcher der Funktionsbereich 13, 13a an den Seiten rundherum verschlossen ist. Es ist denkbar, in der Laser-Fügezone 8 offene Bereiche zu belassen, so dass der Funktionsbereich 13, 13a nicht rundherum verschlossen ist, beispielsweise um einen Kommunikationskanal oder Platz für eine elektrische Verbindung offenzulassen, mit welchem beispielsweise aber auch eine Fluidkommunikation mit der Umgebung aufbaubar ist. Mit anderen Worten kann vorgesehen sein, vorgeplante Stellen bzw. Positionen nicht mit dem fokussierten Laserstrahl 9 zu verschließen, sondern dort den hermetischen Verschluss mit anderen Mitteln wie mit einem Kleber einzurichten. Bevorzugt ist, den Funktionsbereich 13, 13a allseits und lückenlos zu verschließen, um den hermetischen Verschluss des Funktionsbereichs 13, 13a sicherzustellen. In der Kavität 12 ist ein Beherbergungs-Objekt 2, also beispielsweise ein elektronisches Bauteil, oberhalb des Funktionsbereichs 13a, also beispielsweise auf der leitfähigen Schicht 34, angeordnet.

Bezug nehmend auf Fig. 5 ist eine Schnittansicht durch eine erfindungsgemäße Umhäusung 1 im Bereich der Funktionsbereiche 13, 13a gezeigt. Die Umhäusung 1 weist fünf Substratlagen auf, ein Basissubstrat 3, drei Zwischensubstrate 4a, 4b, 4c und ein Abdecksubstrat 5. Die Zwischensubstrate 4a und 4c weisen jeweils eine Kavität 12 auf zur Beherbergung von Bauteilen 2. Das Zwischensubstrat 4b weist elektrische Durchverbindungen bzw. Glasdurchführungen 32 auf, so genannte Through-Glass Vias, so dass die Bauteile des Funktionsbereichs 13 mit denjenigen elektrisch verbunden werden können, die im Funktionsbereich 13a angeordnet sind.

Der Funktionsbereich 13 ist als Kavität 12 ausgebildet, wobei in der Kavität eine Mehrzahl von Bauteilen 2 angeordnet sind. Die Bauteile 2 sind wiederum auf elektrisch leitfähigen Teilschichten 34 angeordnet, welche wiederum mit den Glasdurchführungen 32 elektrisch kontaktiert sind. Die Bauteile 2 des Funktionsbereichs 13 sind somit mittels der Zwischenschicht 4b von den Bauteilen 2 getrennt, die im Funktionsbereich 13a angeordnet sind. Sollte nun bei einem Bauteil 2, welches im Funktionsbereich 13 angeordnet ist, beispielsweise ein Defekt auftreten, eine Flüssigkeit auslaufen, oder eine thermische Überhitzung eintreten, so sind die Bauteile 2, die in dem Funktionsbereich 13a angeordnet sind, hiervon getrennt. Mögliche Folgedefekte von weiteren Bauteilen 2 als Folge auf einen ersten Bauteildefekt können somit verringert oder sogar verhindert werden. In den beiden Kavitäten 12 ist zur weiteren Verbesserung der Isolationswirkung ein Isolationsmedium eingebracht.

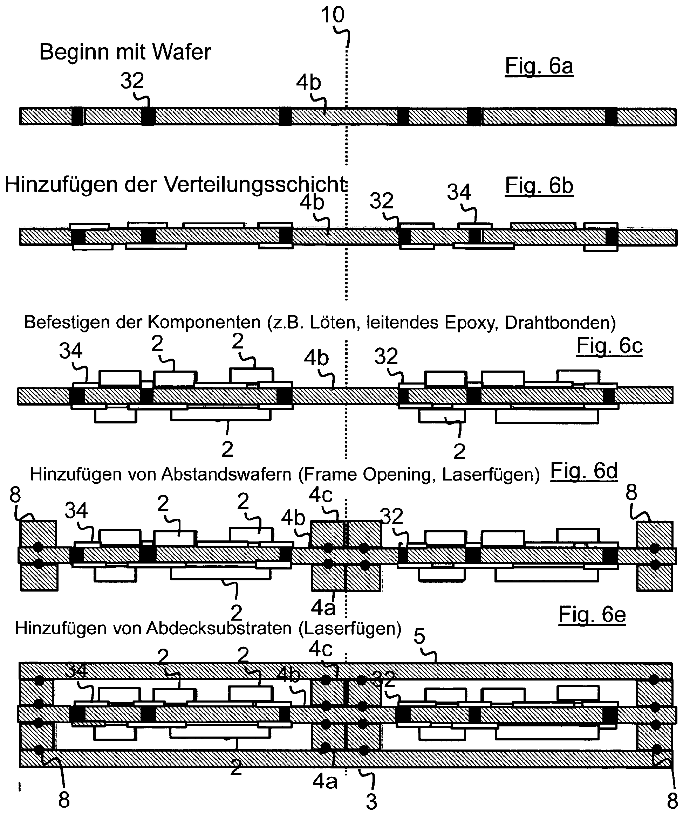

Bezug nehmend auf Fig. 6a bis 6e ist ein Beispiel für die Herstellung einer erfindungsgemäßen Umhäusung 1 gezeigt. Beginnend mit Fig. 6a wird zunächst das mittlere Zwischensubstrat 4b bereitgestellt, welches Glasdurchführungen 32 bereits aufweist bzw. in welches die Glasdurchführungen 32 eingebracht werden. Der Herstellungsprozess wird aus ökonomischen Gründen in diesem Beispiel so durchgeführt, dass mit einem Wafer 4b zwei Umhäusungen 1 aufgebaut werden. Die spätere Trennung der beiden Umhäusungen 1 kann beispielsweise mittels eines Laser-Schneidverfahrens entlang der Trennlinie 10 durchgeführt werden. Alternativ ist es auch denkbar, dass eine gemeinsame Umhäusung gestaltet wird, die nebeneinander angeordnete Kavitäten 12 aufweist, also dem Beispiel der Figur 6e entspricht, ohne dass die beiden Teilbereiche entlang der Trennlinie 10 getrennt werden. In diesem Fall können auch horizontale Glasdurchführungen 32 (nicht dargestellt) vorgesehen sein, die den dargestellten vertikalen Glasdurchführungen 32 entsprechen, zur Verbindung der nebeneinander liegenden Kavitäten 12.

Mit Fig. 6b ist gezeigt, wie auf die mittlere Zwischenschicht 4b auf beiden Seiten jeweils bereichsweise eine elektrische Kontaktschicht 34 aufgebracht wird. Die elektrische Kontaktschicht 34 ist in Kontaktbereiche unterteilt, wobei die Kontaktbereiche mit einer der Glasdurchführungen 32 elektrisch kontaktiert sein können, wie dargestellt. Manche Kontaktbereiche 34 können auch ohne Kontakt zu Glasdurchführungen 32 aufgebracht werden, wenn dies vorteilhaft ist, beispielsweise um zwei Bauteile 2 innerhalb einer Kavität miteinander zu verbinden, aber nicht mit Bauteilen 2, die in einer anderen Kavität 12 innerhalb der Umhäusung 1 angeordnet sind.

Mit Fig. 6c ist das Aufbringen von Beherbergungs-Objekten 2 in den Bereichen gezeigt, die den späteren Kavitäten 12 entsprechen, insbesondere auf Kontaktbereiche 34. Die Komponenten 2 können mit anderen Bauteilen 2 elektrisch verbunden sein, die in derselben Kavität 12 angeordnet sind, und/oder mit anderen Bauteilen 2, die in einer anderen Kavität 12 angeordnet sind, insbesondere mittels der Glasdurchführungen 32. Die Bauteile 2 können beispielsweise mittels Löten, Schweißen, Epoxyd-Leitpaste oder drahtgebunden kontaktiert werden.

Fig. 6d verdeutlicht das Anbringen von Abstandswafern 4a und 4c, je einen oberhalb bzw. unterhalb der Zwischenschicht 4b. Die Abstandswafer 4a bzw. 4c werden an der Zwischenschicht 4b lasergefügt, d.h. es wird je eine Laserbondlinie 8 eingebracht. Fig. 6e verdeutlicht schließlich das Aufbringen des Basissubstrats 3 an der Unterseite der Umhäusung 1 und des Abdecksubstrats 5 an der Oberseite der Umhäusung 1, wobei abermals die Substrate mittels Laserbondlinien 8 gefügt werden.

Es wird also entlang der Kontaktflächen 25 mittels der Laser-Pulstreffer 16 die Laser-Fügezone 8 geschaffen wird, an welcher das Abdecksubstrat 5 mit dem Basissubstrat 3 verschweißt bzw. gefügt ist.

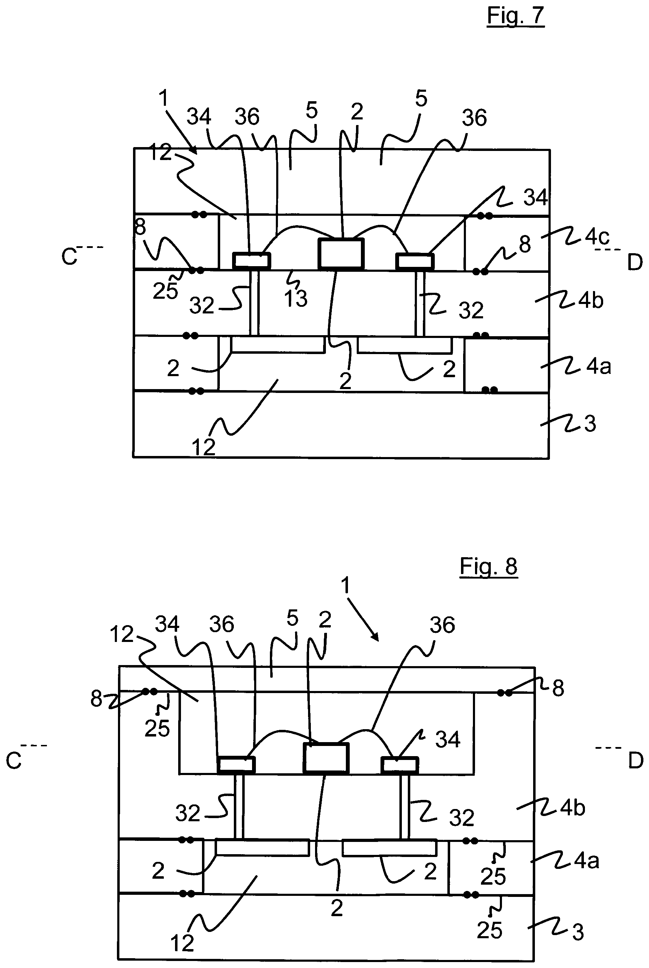

Fig. 7 zeigt eine erfindungsgemäße Ausführungsform der Umhäusung 1 mit einer auf das Basissubstrat 3 aufgesetzten ersten Glaszwischenschicht 4a, einer Bauteilträgerschicht 4b, an welcher die Bauteile 2 angeordnet sind, einer weiteren Glaszwischenschicht 4c sowie einem Abdecksubstrat 5. Die Funktionsbereiche 12, 13, 13a sind in dieser Ausführungsform so angeordnet, dass sie sich jeweils unter- und oberhalb der Bauteilträgerschicht 4b anordnen. Rund um die Kavitäten 12 herum sind die Fügelinie 8 angeordnet, so dass die Kavitäten 12 allseits hermetisch verschlossen sind. Die Umhäusung 1 kann rund oder eckig ausgebildet sein und kann grundsätzlich eine freie Form aufweisen.

Die Beherbergungs-Objekte 2, beispielsweise ein Sensor oder Aktor oder Prozessor, sind auf der Unterseite und der Oberseite der Bauteilträgerschicht 4b angeordnet, beispielsweise dort aufgeklebt oder angelötet. Beidseits des Beherbergungs-Objekts sind Metall-Pads 34 zur elektrischen Kontaktierung des Beherbergungs-Objekts 2 angeordnet. Mittels Kontaktleitungen 32 wie beispielsweise Bond-Drähten, ist das Beherbergungs-Objekt 2 mit weiteren Bauteilen 2 elektrisch kontaktiert. Bei den Metall-Pads 34 kann es sich um Metall-Kontaktflächen handeln. Die Substrate sind jeweils unmittelbar mittels Laserbondlinien 8 miteinander gefügt. In diesem Fall wurden jeweils zwei geschlossen umlaufende Laser-Fügezonen 8 gebildet, indem der Laser 9 zweimal um die Kavität herum entlang der Kontaktflächen 25 bzw. entlang der Außenkanten der Kavitäten 12 geführt wurde, jedoch nicht auf exakt identischem Pfad. Vielmehr wurde der Laser 9 bei jedem Umlauf um die Kavität 12 auf einem lateral versetzten Pfad geführt, so dass zwei nebeneinanderliegende Laser-Fügezonen 8 entstehen. Die Microbonding-Zonen 8 in diesem Beispiel weisen eine Abmessung von beispielsweise 5µm x 10µm oder 10µm x 50µm auf.

Fig. 8 zeigt eine erfindungsgemäße Ausführungsform der Umhäusung 1, wobei eine Kavität 12 in das Zwischensubstrat bzw. die Bauteilträgerschicht 4b eingebracht ist. Beispielsweise kann die Kavität 12 mittels Sandstrahlverfahren in das Zwischensubstrat 4b eingebracht werden, also aus dem Zwischensubstrat 4b ausgehöhlt werden, allgemein mit einem abrasiven Verfahren. Auch ein chemisches Ätzen ist möglich, um die Kavität 12 in die Bauteilträgerschicht 4b einzubringen. Dieser Ausführung ist vorteilhaft, dass das Abdecksusbtrat 5 beispielsweise als einfache Glasplatte ausgeführt werden kann, welche mittels Microbonding und Laserbondlinien 8 mit der Bauteilträgerschicht 4b verbunden ist. Dieser Ausführung ist vorteilhaft, dass die Bauteile, die in der oberen Kavität 12 angeordnet sind, also in der Kavität, die aus dem Zwischensubstrat 4b ausgehöhlt wurde, auch während des Herstellungsprozesses bereits von dem Zwischensubstrat 4b geschützt angeordnet sind. Zudem wird eine Substratschicht eingespart. Gleiche Bezugszeichen zeigen bei allen Ausführungsformen gleiche Merkmale in den Figuren.

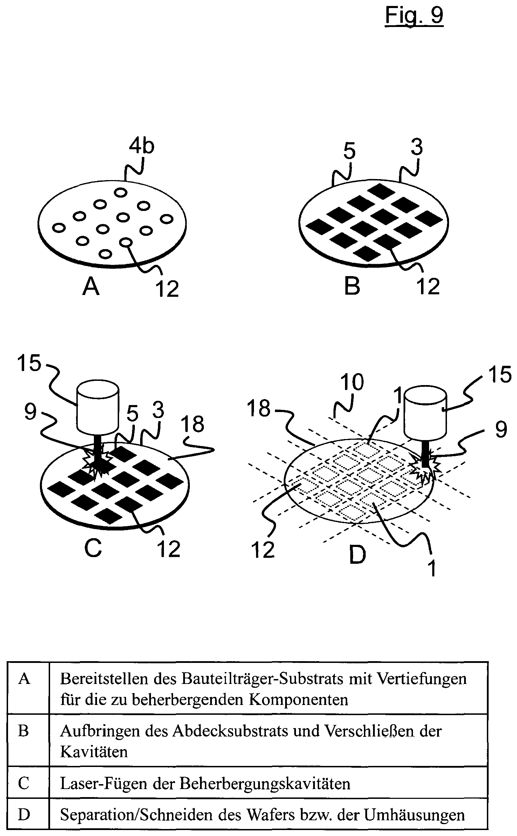

Bezugnehmend auf Fig. 9 ist eine weitere Ausführungsform des Verfahrens zur Herstellung einer Vielzahl von Umhäusungen 1 gezeigt. Es wird die Herstellung der Umhäusungen erläutert, wie sie beispielsweise mit Fig. 8 dargestellt sind. Es ist dem Fachmann klar, dass auch nur eine einzelne Umhäusung 1 hergestellt werden kann, je nach Prozess-Erfordernissen.

In einem Schritt A wird ein gemeinsames Bauteilträgersubstrat 4b bereitgestellt, welches eine Mehrzahl von Vertiefungen 12 aufweist, die den späteren Kavitäten 12 entsprechen, und die beispielsweise mittels eines abrasiven Verfahrens in das Bauteilträgersubstrat 4b eingebracht wurden. In den Vertiefungen 12 werden jeweils Beherbergungs-Objekte 2 angeordnet, beispielsweise an vorgesehenen bzw. bereits dort angebrachten Kontakten 34 (vgl. Fig. 6a-6e) angelötet. In einem Schritt B wird auf dem Bauteilträgersubstrat 4b ein gemeinsames Abdecksubstrat 5 angebracht, d.h. zu jeder Vertiefung wird eine eigene Kavität 12 erzeugt. Es können mehrere Beherbergungs-Objekte 2 in jeweils einer gemeinsamen Kavität 12 beherbergt werden.

Anschließend kann auf der Unterseite des Bauteilträgersubstrats 4b die Anbringung weiterer Bauteile 2 und die Erzeugung weiterer Kavitäten 12 vorgesehen sein, vgl. Fig. 6c bis 6e und 8. Hierfür würde auf der Unterseite des Bauteilträgersubstrats 4b eine weitere Glaszwischenschicht 4a angeordnet werden und darunter ein Basissubstrat 3. Dies ist im Sinne dieses Herstellungsverfahrens optional.

Mit Schritt C wird der fertige Substratstapel mittels Laser gefügt, so dass die jeweiligen Beherbergungskavitäten 12 hermetisch verschlossen werden, also das Verschließen der Kavitäten 12 allseits entlang der Kontaktflächen 25 und das Einbringen der zumindest einen Laserbondlinie 8 pro Umhäusung 1. Hierfür wird eine Lasereinheit 15 von oberhalb des Abdecksubstrats 5 über die Oberfläche des Abdecksubstrats 5 geführt und dabei punktuell ein fokussierter Laserstrahl 9 auf die zu fügenden Zonen gerichtet, also insbesondere auf die Kontaktflächen 25. Nach Abschluss des Schritts C des Herstellungsverfahrens sind alle Kavitäten 12 hermetisch geschlossen. Es ist möglich, die einzelnen Umhäusungen 1 nach Schritt C mittels Schneidverfahren zu vereinzeln, und somit einzelne getrennte Umhäusungen 1 zu erhalten.

In Schritt D werden die Bauteile entlang von Trenn- bzw. Schneidlinien 10 voneinander getrennt. Hierfür kann ggf. derselbe Laser eingesetzt werden wie auch für das Laser-Fügen in Schritt C. Es kann aber auch ein herkömmliches Schneidverfahren eingesetzt werden, wenn dies vorteilhaft ist.

Es ist dem Fachmann ersichtlich, dass die vorstehend beschriebenen Ausführungsformen beispielhaft zu verstehen sind und die Erfindung nicht auf diese beschränkt ist, sondern in vielfältiger Weise variiert werden kann, ohne den Schutzbereich der Ansprüche zu verlassen. In allen Figuren bezeichnen gleiche Bezugszeichen gleiche Merkmale, so dass Beschreibungen von Merkmalen, die ggf. nur in einer oder jedenfalls nicht hinsichtlich aller Figuren erwähnt sind, auch auf diese Figuren übertragen werden können, hinsichtlich welchen das Merkmal in der Beschreibung nicht explizit beschrieben ist.

### Bezugszeichenliste:

- 1: Hermetisch geschlossene Umhäusung
- 2: Beherbergungs-Objekt, Funktionsbaustein
- 3: Unteres Substrat, Schicht oder Wafer, Basissubstrat bzw. untere Abdeckung
- 4, 4a, 4b, 4c, 4d, 4e, 4f: Zwischenschicht
- 5: Oberes Substrat, Schicht oder Wafer, Abdecksubstrat bzw. obere Abdeckung
- 8: Laser-Fügezone
- 9: fokussierter Laserstrahl
- 10: Trenn- bzw. Schneidlinie
- 12: Beherbergungs-Kavität
- 13: Funktionsbereich
- 13a: zweiter Funktionsbereich
- 14: Kante
- 15: Lasereinheit zum Fügen und/oder Schneiden
- 16: Laser-Pulstrefferbereich
- 18: Substratstapel
- 21: Rand der Kavität
- 22: Unterseite der Kavität
- 23: Oberseite der Kavität
- 25: Kontaktfläche
- 32: Glasdurchführung, through-glass-via
- 34: elektrische Kontaktschicht

## Patentansprüche

1. Umhäusung
(1) zur Wärmekapselung eines Funktionsbereichs, umfassend:
ein Basissubstrat (3),
ein Abdecksubstrat (5), wobei das Basissubstrat zusammen mit dem Abdecksubstrat zumindest einen Teil der Umhäusung oder die Umhäusung bildet,
zumindest einen von der Umhäusung (1) hermetisch verschlossenen Funktionsbereich (12, 13, 13a), insbesondere eine Kavität,
wobei die Substrate der Umhäusung jeweils mittels zumindest einer Laserbondlinie hermetisch dicht miteinander gefügt sind,
wobei jede Laserbondlinie eine Höhe (HL) senkrecht zur entsprechenden Verbindungsebene aufweist,
wobei in dem Funktionsbereich der Umhäusung Wärme erzeugt werden kann,
wobei zumindest das Basissubstrat und/oder das Abdecksubstrat als thermischer Isolator ausgestaltet ist und aus einem Material besteht, welches ein glasartiges Material umfasst, welches Glas, Glaskeramik oder eine Kombination der vorgenannten Materialien umfasst, **gekennzeichnet durch**
ferner umfassend zumindest ein zwischen dem Basissubstrat (3) und dem Abdecksubstrat (5) angeordnetes Zwischensubstrat (4, 4a, 4b, 4c, 4d, 4e, 4f).sowie
Vias (32) in dem zumindest zwei Kavitäten (12) trennenden Zwischensubstrat

2. Hermetisch verschlossene Umhäusung (1) nach vorstehendem Anspruch ,
wobei das zumindest eine Zwischensubstrat (4, 4a, 4b, 4c, 4d, 4e, 4f) aus einem Material niedriger Wärmeleitfähigkeit besteht, welches ein glasartiges Material umfasst, welches Glas, Glaskeramik oder eine Kombination der vorgenannten Materialien umfasst.

3. Hermetisch verschlossene Umhäusung (1) nach mindestens einem der vorstehenden Ansprüche, wobei zumindest eine der Laserbondlinien (8) den Funktionsbereich (12, 13, 13a) in einem Abstand (DF) umlaufend umschließt, und/oder
wobei der Funktionsbereich (12, 13, 13a) hergerichtet ist zur Aufnahme zumindest eines Beherbergungs-Objekts (2), wie beispielsweise ein elektronischer Schaltkreis, ein Sensor oder MEMS, so dass innerhalb der Umhäusung (1) zumindest ein Beherbergungs-Objekt (2) angeordnet ist,
wobei das zumindest eine Beherbergungs-Objekt (2) beispielsweise einen Leistungshalbleiter-Chip, z.B. eine GaN-LED, einen SiC-, GaAs- oder GaN-Leistungstransistor umfasst, und/oder
wobei das zumindest eine Beherbergungs-Objekt (2) insbesondere Teil der Umhäusung ist.

4. Hermetisch verschlossene Umhäusung (1) nach dem vorstehenden Anspruch,
wobei das Beherbergungsobjekt (2) in einer der zumindest zwei Kavitäten (12) angeordnet ist, und/oder
wobei die Umhäusung mehrere Kavitäten (12) umfasst zum Aufnehmen zumindest eines Beherbergungsobjekts in jeweils einer Kavität, und/oder
wobei mehrere Beherbergungs-Objekte (2) in der Umhäusung (1) angeordnet sind, und wobei die Beherbergungs-Objekte auf verschiedene Kavitäten (12) aufgeteilt sind.

5. Hermetisch verschlossene Umhäusung (1) nach mindestens einem der vorstehenden Ansprüche,
wobei in einer der zumindest zwei n Kavitäten (12) ein Isolationsmedium eingebracht ist zur Verbesserung der Isolationswirkung, wobei das Isolationsmedium insbesondere ein Fluid ist, beispielsweise eine thermisch isolierende Flüssigkeit oder ein isolierendes Gas oder Vakuum.

6. Hermetisch verschlossene Umhäusung (1) nach mindestens einem der vorstehenden Ansprüche,
bei welcher die Vias (32), zum elektrischen Verbinden der in den Kavitäten (12) angeordneten Beherbergungs-Objekte (2) vorgesehen sind, und/oder
ferner umfassend zumindest eine elektrische Verbindungsschicht auf zumindest einem der Zwischensubstrate (4, 4a, 4b, 4c, 4d, 4e, 4f, 4g), und/oder
wobei zumindest eines der Substrate (3, 4, 4a, 4b, 4c, 4d, 4e, 4f, 4g, 5) als Mehrschichtverbund bereitgestellt wird, beispielsweise umfassend eine oder mehrere Beschichtungslagen oder Vorspannungszonen, und/oder beispielsweise umfassend ein oder mehrere Substrate.

7. Hermetisch verschlossene Umhäusung (1) nach mindestens einem der vorstehenden Ansprüche,
wobei die Laserbondlinien (8) mit der Höhe (HL) in das Material des über der Laserbondlinie angeordneten Substrats (4, 4a, 4b, 4c, 4d, 4e, 4f, 5) hineinreichen und wobei das Basissubstrat (3) mit dem oder den Zwischensubstraten und dem Abdecksubstrat (5) schmelzend miteinander gefügt ist, und/oder
wobei in zumindest einem der Substrate (3, 4, 5) ein Marker eingebracht ist.

8. Hermetisch verschlossene Umhäusung (1) nach mindestens einem der vorstehenden Ansprüche, wobei die Umhäusung (1) zumindest teilweise und/oder bereichsweise für einen Wellenlängenbereich transparent ist.

9. Hermetisch verschlossene Umhäusung (1) nach mindestens einem der vorstehenden Ansprüche,
wobei der zumindest eine Funktionsbereich der Umhäusung eingerichtet ist zur Aufnahme zumindest eines Beherbergungs-Objekts einer Größe von 10mm x 10mm oder kleiner, bevorzugt einer Größe von 5mm x 5mm oder kleiner, weiter bevorzugt von 2mm x 2mm oder kleiner oder auch 1mm x 1mm oder kleiner.

10. Verfahren zum Bereitstellen einer hermetisch dichten Umhäusung (1), wobei von der Umhäusung (1) ein Funktionsbereich (12, 13, 13a), somit eine Kavität (12), umschlossen wird, mit den Schritten:
- Bereitstellen eines Basissubstrats (3), zumindest eines Zwischensubstrats (4, 4a, 4b, 4c, 4d, 4e, 4f) und eines Abdecksubstrats (5), wobei das Abdecksubstrat (5) zumindest teilweise oder bereichsweise zumindest für einen Wellenlängenbereich transparent ist und daher ein transparentes Abdecksubstrat ist,
- Anordnen von zumindest einem Beherbergungs-Objekt (2) in der Kavität,
- Anordnen des Abdecksubstrats (5) auf dem Basissubstrat (3) oberhalb des zumindest einen Beherbergungs-Objekts (2), wobei sich zwischen dem Basissubstrat (3) dem Zwischensubstrat (4, 4a, 4b, 4c, 4d, 4e, 4f) und dem Abdecksubstrat (5) jeweils zumindest eine Kontaktfläche (25) ausbildet,
- hermetisch dichtes Verschließen der Kavitäten durch Ausbilden zumindest jeweils einer Laserbondlinie (8) auf den Kontaktflächen ,
wobei zumindest eines aus Basissubstrat oder Abdecksubstrat thermisch isolierend ausgestaltet ist und aus einem Material besteht, welches ein glasartiges Material umfasst, welches Glas, Glaskeramik oder eine Kombination der vorgenannten Materialien umfasst,
wobei das Zwischensubstrat (4, 4a, 4b, 4c, 4d, 4e, 4f, 4g) zumindest zwei Kavitäten (12) trennt und Vias (32) aufweist.

11. Verfahren nach dem vorstehenden Anspruch, wobei mittels des Verfahrens eine Umhäusung (1) nach einem der Ansprüche 1 bis 9 gebildet wird.

12. Verfahren nach mindestens einem der Ansprüche 10 oder 11,
wobei ein Laserstrahl (9) umlaufend um den Funktionsbereich (12, 13, 13a) herumgeführt wird zur Bildung der Laserbondlinie (8), so dass der Funktionsbereich entlang der Kontaktfläche (25) umlaufend hermetisch verschlossen wird, gegebenenfalls kann der Laserstrahl mehrfach umlaufend herumgeführt werden und/oder gegebenenfalls eine Mehrzahl von Laserbondlinien (8) ausgebildet werden.

13. Verwendung einer nach dem Verfahren gemäß mindestens einem der Ansprüche 10 bis 12 hergestellten Umhäusung (1) mit darin eingeschlossener hermetisch verschlossener Beherbergungs-Kavität (12) als medizinisches Implantat oder als Sensor.

## Claims

1. An enclosure (1) for thermal encapsulation of a functional area, comprising:
a base substrate (3);
a cover substrate (5), the base substrate together with the cover substrate defining at least part of the enclosure or defining the enclosure;
at least one functional area (12, 13, 13a) hermetically sealed by the enclosure (1), in particular a cavity;
wherein the substrates of the enclosure are hermetically joined to one another by at least one laser bonding line;
wherein each laser bonding line has a height (HL) perpendicular to the respective bonding plane;
wherein heat can be generated inside the functional area of the enclosure;
wherein at least the base substrate and/or the cover substrate is designed as a thermal insulator and is made of a material which comprises a vitreous material comprising glass or glass ceramics or a combination of the aforementioned materials;
**characterized by**
further comprising at least one intermediate substrate (4, 4a, 4b, 4c, 4d, 4e, 4f) disposed between the base substrate (3) and the cover substrate (5); and
vias (32) in the intermediate substrate which separates at least two cavities (12).

2. The hermetically sealed enclosure (1) according to the preceding claim,
wherein the at least one intermediate substrate (4, 4a, 4b, 4c, 4d, 4e, 4f) is made of a material of low thermal conductivity, which comprises a vitreous material comprising glass or glass ceramics or a combination of the aforementioned materials.

3. The hermetically sealed enclosure (1) according to at least one of the preceding claims, wherein at least one of the laser bonding lines (8) circumferentially surrounds the functional area (12, 13, 13a) at a distance (DF) therefrom; and/or
wherein the functional area (12, 13, 13a) is adapted to accommodate at least one accommodation item (2) such as an electronic circuit, a sensor, or an MEMS, so that at least one accommodation item (2) is disposed inside the enclosure (1);
wherein the at least one accommodation item (2) comprises, for example, a power semiconductor chip, e.g. a GaN LED, SiC power transistor, GaAs power transistor or GaN power transistor; and/or
wherein the at least one accommodation item (2) in particular forms part of the enclosure.

4. The hermetically sealed enclosure (1) according to the preceding claim,
wherein the accommodation item (2) is disposed in one of the at least two cavities (12); and/or
wherein the enclosure comprises a plurality of cavities (12) for accommodating at least one accommodation item in each respective cavity; and/or
wherein a plurality of accommodation items (2) are disposed inside the enclosure (1), and wherein the accommodation items are distributed to different cavities (12).

5. The hermetically sealed enclosure (1) according to at least one of the preceding claims,
wherein an insulating medium is included in one of the at least two cavities (12) to improve the insulating effect, the insulating medium in particular being a fluid such as a thermally insulating liquid or an insulating gas, or vacuum.

6. The hermetically sealed enclosure (1) according to at least one of the preceding claims,
wherein the vias (32) are provided for electrically connecting the accommodation items (2) disposed in the cavities (12); and/or
further comprising at least one electrical connection layer on at least one of the intermediate substrates (4, 4a, 4b, 4c, 4d, 4e, 4f, 4g); and/or
wherein at least one of the substrates (3, 4, 4a, 4b, 4c, 4d, 4e, 4f, 4g, 5) is provided in the form of a multilayer composite, for example comprising one or more coating layers or pre-stressed zones, and/or for example comprising one or more substrates.

7. The hermetically sealed enclosure (1) according to at least one of the preceding claims,
wherein the laser bonding lines (8) having the height (HL) extend into the material of the substrate (4, 4a, 4b, 4c, 4d, 4e, 4f, 5) which is disposed above the laser bonding line, and wherein the base substrate (3), the one or more intermediate substrate(s) and the cover substrate (5) are joined together by being fused to one another; and/or
wherein a marker is incorporated in at least one of the substrates (3, 4, 5).

8. The hermetically sealed enclosure (1) according to at least one of the preceding claims, wherein the enclosure (1) is transparent for a range of wavelengths at least partially and/or in sections thereof.

9. The hermetically sealed enclosure (1) according to at least one of the preceding claims,
wherein the at least one functional area of the enclosure is adapted for accommodating at least one accommodation item having a size of 10 mm x 10 mm or less, preferably a size of 5 mm x 5 mm or less, more preferably 2 mm x 2 mm or less, or even 1 mm x 1 mm or less.

10. A method for providing a hermetically sealed enclosure (1), the enclosure (1) enclosing a functional area (12, 13, 13a), i.e. a cavity (12), comprising the steps of:
- providing a base substrate (3), at least one intermediate substrate (4, 4a, 4b, 4c, 4d, 4e, 4f) and a cover substrate (5), the cover substrate (5) being transparent for at least one range of wavelengths at least partially or in sections thereof and thus constituting a transparent cover substrate;
- arranging at least one accommodation item (2) inside the cavity;
- arranging the cover substrate (5) on the base substrate (3) above the at least one accommodation item (2) thereby creating at least one respective contact area (25) between the base substrate (3), the intermediate substrate (4, 4a, 4b, 4c, 4d, 4e, 4f) and the cover substrate (5);
- hermetically sealing the cavities by forming at least one respective laser bonding line (8) along the contact areas;
wherein at least one of the base substrate or the cover substrate is designed to be thermally insulating and is made of a material comprising a vitreous material which comprises glass or glass ceramics or a combination of the aforementioned materials;
wherein the intermediate substrate (4, 4a, 4b, 4c, 4d, 4e, 4f) separates at least two cavities (12) and includes vias (32).

11. The method according to the preceding claim, wherein the method is used to produce an enclosure (1) according to any one of claims 1 to 9.

12. The method according to at least one of claims 10 or 11,
wherein a laser beam (9) is directed circumferentially around the functional area (12, 13, 13a) to produce the laser bonding line (8), so that the functional area is hermetically sealed circumferentially along the contact area (25), wherein, optionally, the laser beam can be directed circumferentially around repeatedly and/or, optionally, a plurality of laser bonding lines (8) can be formed.

13. Use of an enclosure (1) with a hermetically sealed accommodation cavity (12) enclosed therein as produced according to the method of at least one of claims 10 to 12 as a medical implant or as a sensor.

## Revendications

1. Enceinte (1) destinée à l'encapsulage thermique d'une zone fonctionnelle, comprenant
un substrat de base (3),
un substrat de recouvrement (5), le substrat de base formant avec le substrat de recouvrement au moins une partie de l'enceinte ou formant l'enceinte,
au moins une zone fonctionnelle (12, 13, 13a), en particulier une cavité, hermétiquement scellée par l'enceinte (1),
les substrats de l'enceinte étant assemblés respectivement de manière hermétiquement étanche l'un à l'autre à l'aide d'au moins une ligne de fixation au laser,
chaque ligne de fixation au laser présentant une hauteur (HL) perpendiculaire au plan de liaison correspondant,
avec possibilité de génération de chaleur dans la zone fonctionnelle de l'enceinte,
au moins le substrat de base et/ou le substrat de recouvrement étant réalisé(s) comme isolateur thermique, et étant constitué(s) d'un matériau qui comporte un matériau de type verre, englobant un verre, une vitrocéramique ou une combinaison des matériaux précités,
**caractérisée en ce que**
elle comprend en outre au moins un substrat intermédiaire (4, 4a, 4b, 4c, 4d, 4e, 4f) disposé entre le substrat de base (3) et le substrat de recouvrement (5), ainsi que des vias (32) dans le substrat intermédiaire séparant au moins deux cavités (12).

2. Enceinte (1) hermétiquement scellée selon la revendication précédente,
dans laquelle le substrat intermédiaire (4, 4a, 4b, 4c, 4d, 4e, 4f), au nombre d'au moins un, est constitué d'un matériau à faible conductivité thermique qui comporte un matériau de type verre, lequel englobe un verre, une vitrocéramique ou une combinaison des matériaux précités.

3. Enceinte (1) hermétiquement scellée selon au moins une des revendications précédentes, dans laquelle au moins une des lignes de fixation au laser (8) entoure de manière continue la zone fonctionnelle (12, 13, 13a), à distance (DF) de celle-ci, et/ou
dans laquelle la zone fonctionnelle (12, 13, 13a) est agencée pour accueillir au moins un objet à loger (2), par exemple un circuit électronique, un capteur ou un MEMS, de sorte qu'au moins un objet à loger (2) est disposé à l'intérieur de l'enceinte (1),
l'objet à loger (2), au nombre d'au moins un, comportant par exemple une puce de semi-conducteur de puissance, telle qu'une DEL GaN, un transistor de puissance SiC, GaAS ou GaN, et/ou
l'objet à loger (2), au nombre d'au moins un, faisant notamment partie de l'enceinte.

4. Enceinte (1) hermétiquement scellée selon la revendication précédente,
dans laquelle l'objet à loger (2) est disposé dans une des cavités (12), au nombre d'au moins deux, et/ou
dans laquelle l'enceinte comporte plusieurs cavités (12) destinées à accueillir au moins un objet à loger, respectivement dans une cavité, et/ou
dans laquelle plusieurs objets à loger (2) sont disposés dans l'enceinte (1), et les objets à loger sont répartis sur différentes cavités (12).

5. Enceinte (1) hermétiquement scellée selon au moins une des revendications précédentes,
dans laquelle un milieu isolant est placé dans l'une des n cavités (12), au nombre d'au moins deux, aux fins d'améliorer l'effet isolant, le milieu isolant étant en particulier un fluide, par exemple un liquide thermiquement isolant ou un gaz isolant ou un vide.

6. Enceinte (1) hermétiquement scellée selon au moins une des revendications précédentes,
dans laquelle les vias (32) sont prévus pour la liaison électrique des objets à loger (2) disposés dans les cavités (12), et/ou
comprenant en outre au moins une couche de liaison électrique sur au moins l'un des substrats intermédiaires (4, 4a, 4b, 4c, 4d, 4e, 4f, 4g), et/ou
dans laquelle au moins un des substrats (3, 4, 4a, 4b 4c, 4d, 4e, 4f, 4g, 5) est réalisé sous forme de structure composite multicouche, comprenant par exemple une ou plusieurs couches de revêtement ou de zones de précontrainte, et/ou comprenant par exemple un ou plusieurs substrats.

7. Enceinte (1) hermétiquement scellée selon au moins une des revendications précédentes,
dans laquelle les lignes de fixation au laser (8) avec la hauteur (HL) s'étendent dans le matériau du substrat (4, 4a, 4b 4c, 4d, 4e, 4f, 5) disposé au-dessus de la ligne de fixation au laser, et dans laquelle le substrat de base (3) est assemblé par fusion avec le ou les substrats intermédiaires et le substrat de recouvrement (5), et/ou
dans laquelle un marqueur est placé dans au moins un des substrats (3, 4, 5).

8. Enceinte (1) hermétiquement scellée selon au moins une des revendications précédentes, dans laquelle l'enceinte (1) est transparente pour une gamme de longueurs d'ondes, au moins en partie et/ou par portions.

9. Enceinte (1) hermétiquement scellée selon au moins une des revendications précédentes,
dans laquelle la zone fonctionnelle, au nombre d'au moins une, de l'enceinte est agencée pour accueillir au moins un objet à loger, d'une dimension de 10 mm x 10 mm ou moins, de préférence d'une dimension de 5 mm x 5 mm ou moins, et de manière particulièrement avantageuse de 2 mm x 2mm ou moins, voire de 1 mm x 1 mm ou moins.

10. Procédé de mise à disposition d'une enceinte (1) hermétiquement étanche, l'enceinte (1) entourant une zone fonctionnelle (12, 13, 13a) et par conséquent une cavité (12), le procédé comprenant les étapes suivantes :
- mise à disposition d'un substrat de base (3), d'au moins un substrat intermédiaire (4, 4a, 4b, 4c, 4d, 4e, 4f) et d'un substrat de recouvrement (5), le substrat de recouvrement (5) étant transparent pour une gamme de longueurs d'ondes, au moins en partie et/ou par portions, et étant par conséquent un substrat de recouvrement transparent,
- mise en place d'au moins un objet à loger (2) dans la cavité,
- mise en place du substrat de recouvrement (5) sur le substrat de base (3), au-dessus de l'objet à loger (2), au nombre d'au moins un, au moins une surface de contact (25) se formant respectivement entre le substrat de base (3), le substrat intermédiaire (4, 4a, 4b, 4c, 4d, 4e, 4f) et le substrat de recouvrement (5),
- scellement hermétiquement étanche des cavités, par formation respectivement d'au moins une ligne de fixation au laser (8) sur les surfaces de contact,
au moins un substrat parmi le substrat de base et le substrat de recouvrement étant réalisé de manière thermiquement isolante, et étant constitué d'un matériau qui comprend un matériau de type verre, lequel englobe un verre, une vitrocéramique ou une combinaison des matériaux précités,
le substrat intermédiaire (4, 4a, 4b, 4c, 4d, 4e, 4f, 4g) présentant au moins deux cavités (12) et vias (32).

11. Procédé selon la revendication précédente, le procédé permettant de réaliser une enceinte (1) selon une des revendications précédentes 1 à 9.

12. Procédé selon au moins une des revendications 10 ou 11,
selon lequel un faisceau laser (9) est guidé en continu sur le pourtour de la zone fonctionnelle (12, 13, 13a), aux fins de réaliser la ligne de fixation au laser (8), de sorte que la zone fonctionnelle est scellée hermétiquement sur le pourtour, le long de la surface de contact (25), le faisceau laser pouvant le cas échéant être guidé plusieurs fois sur le pourtour et/ou plusieurs lignes de fixation au laser (8) pouvant le cas échéant être réalisées.

13. Utilisation d'une enceinte (1) fabriquée conformément au procédé selon au moins une des revendications 10 à 12, comportant une cavité d'accueil (12) scellée hermétiquement et enfermée dans l'enceinte, en tant qu'implant médical ou en tant que capteur.
